# EUROPEAN PATENT APPLICATION

(11) **EP 4 064 300 A1**
(43) Date of publication of application: **28.09.2022**
(21) Application number: 22163398.5
(22) Date of filing: 21.03.2022
(51) Int. Cl.: H01C 10/10, H02N 1/04, H01G 5/013, H01G 7/02, H01C 10/12, H01C 10/23, H01G 5/14, H01L 41/08

(54) **ELEMENT**

(30) Priority: 23.03.2021 JP 2021049141
(71) Applicant: Ricoh Company, Ltd., Tokyo 143-8555 (JP)
(72) Inventor: Miyazawa, Hideyuki, Tokyo, 143-8555 (JP); Kondoh, Tsuneaki, Tokyo, 143-8555 (JP); Arizumi, Yuko, Tokyo, 143-8555 (JP); Natori, Junichiro, Tokyo, 143-8555 (JP); Sugawara, Tomoaki, Tokyo, 143-8555 (JP); Nakashima, Makito, Tokyo, 143-8555 (JP); Endoh, Takeshi, Tokyo, 143-8555 (JP); Otagiri, Mizuki, Tokyo, 143-8555 (JP); Hoshikawa, Yuki, Tokyo, 143-8555 (JP)
(74) Representative: Marks & Clerk LLP

(57) **Abstract**

An element (1) includes an upper electrode (101), a flexible intermediate layer (102), and a lower electrode (103). The upper electrode (101) having an uneven structure. The lower electrode (103) is closely attached to the intermediate layer (102). The element is configured to generate an electrical signal due to contact and separation between the upper electrode (101) and the intermediate layer (102). The lower electrode (103) is configured to take a shape fittable to the uneven structure when the upper electrode (101) and the intermediate layer (102) come into contact with each other.

## Description

### BACKGROUND OF THE INVENTION

### 1. Field of the Invention

The present invention relates to an element.

### 2. Description of the Related Art

A technology for increasing a power generation amount of a flexible power generation element (one example of an element) has been developed.

For example, a power generation element that includes an upper electrode having an uneven structure, a flexible intermediate layer, and a lower electrode that is closely attached to the intermediate layer has been developed.

Meanwhile, there is a demand to further increase the power generation amount of the flexible power generation element.

The present invention has been conceived in view of the foregoing situation, and an object of the present invention is to provide an element that is able to further increase a power generation amount of a flexible element.

Conventional techniques are described in Japanese Unexamined Patent Application Publication No. 2011-172366, and Japanese Patent No. 5945102.

### SUMMARY OF THE INVENTION

According to an aspect of the present invention, an element includes an upper electrode, a flexible intermediate layer, and a lower electrode. The upper electrode having an uneven structure. The lower electrode is closely attached to the intermediate layer. The element is configured to generate an electrical signal due to contact and separation between the upper electrode and the intermediate layer. The lower electrode is configured to take a shape fittable to the uneven structure when the upper electrode and the intermediate layer come into contact with each other.

### BRIEF DESCRIPTION OF THE DRAWINGS

FIGS. 1A and 1B are diagrams for explaining an example of a configuration of a power generation element according to one embodiment;
FIGS. 2A and 2B are diagrams for explaining an example of operation of a lower electrode included in the power generation element according to the present embodiment;
FIG. 3 is a diagram illustrating an example of a power generation amount of the power generation element according to the present embodiment;
FIG. 4 is a diagram illustrating an example of the power generation amount of the power generation element according to the present embodiment;
FIG. 5 is a diagram illustrating an example of the power generation amount of the power generation element according to the present embodiment;
FIG. 6 is a diagram illustrating an example of a measurement apparatus used to measure a power generation amount of a power generation according to a first example;
FIG. 7 is a diagram illustrating an example of a material of a lower electrode used to measure the power generation amount of the power generation element according to the first example;
FIG. 8 is a diagram illustrating an example of a measurement result of the power generation amount of the power generation element according to the first example;
FIG. 9 is a diagram illustrating an example of a measurement result of a power generation amount of a power generation element according to a second example; and
FIG. 10 is a diagram illustrating an example of a measurement result of a power generation amount of a power generation element according to a third example.

The accompanying drawings are intended to depict exemplary embodiments of the present invention and should not be interpreted to limit the scope thereof. Identical or similar reference numerals designate identical or similar components throughout the various drawings.

### DESCRIPTION OF THE EMBODIMENTS

The terminology used herein is for the purpose of describing particular embodiments only and is not intended to be limiting of the present invention.

As used herein, the singular forms "a", "an" and "the" are intended to include the plural forms as well, unless the context clearly indicates otherwise.

In describing preferred embodiments illustrated in the drawings, specific terminology may be employed for the sake of clarity. However, the disclosure of this patent specification is not intended to be limited to the specific terminology so selected, and it is to be understood that each specific element includes all technical equivalents that have the same function, operate in a similar manner, and achieve a similar result.

An embodiment of the present invention will be described in detail below with reference to the drawings. Embodiments of an element will be described in detail below with reference to the accompanying drawings.

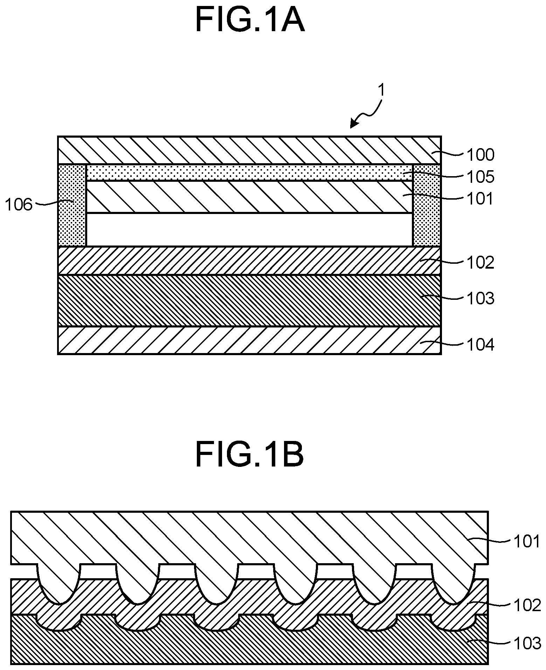

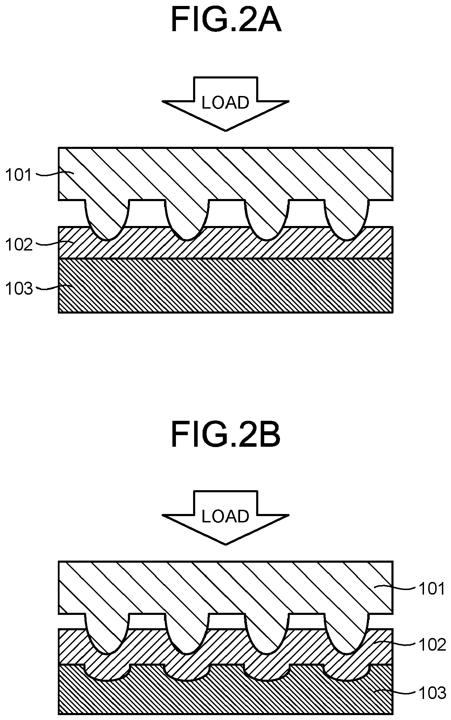

FIGS. 1A and 1B are diagrams for explaining an example of a configuration of a power generation element according to one embodiment. FIGS. 2A and 2B are diagrams for explaining an example of operation of a lower electrode included in the power generation element according to the present embodiment. A power generation element 1 (one example of an element) according to the present embodiment includes, as illustrated in FIG. 1A, an upper cover 100, an upper electrode 101 (one example of a first electrode), an intermediate layer 102, a lower electrode 103 (one example of a second electrode), and a lower cover 104. Specifically, the power generation element 1 is an element in which the upper cover 100, the upper electrode 101, the intermediate layer 102, the lower electrode 103, and the lower cover 104 are laminated in this order, and may include other members if needed.

The power generation element 1 is suitable for various sensors, such as an ultrasonic sensor, a pressure sensor, a tactile sensor, a distortion sensor, an acceleration sensor, a shock sensor, a vibration sensor, a pressure-sensitive sensor, an electrical field sensor, and a sound pressure sensor, in particular, is suitable for use for a wearable sensor because of no need of high voltage. Further, as a piezoelectric film with good workability, the power generation element 1 is suitable for a headphone, a speaker, a microphone, a water microphone, a display, a fan, a pump, a variable focus mirror, an ultrasonic transducer, a piezoelectric transformer, a sound shielding material, a sound insulation material, an actuator, a keyboard, and the like. Furthermore, the power generation element 1 may be used for an acoustic apparatus, an information processor, a measurement apparatus, a medical apparatus, a damping material (damper) used for a vehicle, a building, and a sports equipment, such as a ski or a racket, and other fields.

Moreover, the power generation element 1 is suitable for the following uses.
- Power generation by natural energy, such as wave power, water power, or wind power.
- Power generation by human walking in the form of being embedded in shoes, clothes, a floor, or an accessory.
- Power generation by vibration due to running in the form of being embedded in an automobile tire or the like.
Further, it is expected that the power generation element 1 is formed on a flexible substrate and used as a plate-shaped power generator, a secondary battery that is charged by reversely applying voltage, or a new actuator (artificial muscle).

The upper cover 100 is a cover that covers a surface of the upper electrode 101 opposite to a surface that is in contact with the intermediate layer 102. Further, the upper cover 100 is bonded to the upper electrode 101 with a double-stick tape 105 or the like.

As a material of the upper electrode 101 and the lower electrode 103, for example, a metal, a carbon-based conductive material, a conductive rubber composition, a conductive polymer, an oxide, or the like may be adopted.

Examples of the metal include gold, silver, copper, aluminum, stainless steel, tantalum, nickel, and phosphor bronze.

Examples of the carbon-based conductive material include a carbon nanotube, a carbon fiber, and graphite.

Examples of the conductive rubber composition include a composition containing conductive filler and rubber.

Examples of the conductive filler include a carbon material (for example, Ketjen black, acetylene black, graphite, a carbonaceous fiber, a carbon fiber (CF), a carbon nanofiber (CNF), a carbon nanotube (CNT), graphene, and the like), metal filler (gold, silver, platinum, copper, aluminum, nickel, and the like), a conductive polymer material (derivatives of any of polythiophene, polyacetylene, polyaniline, polypyrrole, poly(p-phenylene), and poly(p-phenylene vinylene), those obtained by adding a dopant represented by anion or cation to the derivatives as described above, and the like), and ionic liquid. One of the above-described materials may be used alone or two or more of the above-described materials may be used in combination.

Examples of the rubber include silicone rubber, acrylic rubber, chloroprene rubber, polysulfide rubber, urethane rubber, butyl rubber, natural rubber, ethylene-propylene rubber, nitrile rubber, fluorine-contained rubber, isoprene rubber, butadiene rubber, styrene-butadiene rubber, acrylonitrile-butadiene rubber, ethylene-propylene-diene rubber, chlorosulfonated polyethylene synthetic rubber, polyisobutylene, and modified silicone. One of the above-described materials may be used alone or two or more of the above-described materials may be used in combination.

Examples of the conductive polymer include poly(3,4-ethylenedioxythiophene) (PEDOT), polypyrrole, and polyaniline.

Examples of the oxide include indium tin oxide (ITO), indium zinc oxide (IZO), and zinc oxide.

Examples of a form of the upper electrode 101 and a form of the lower electrode 103 include a sheet, a film, a thin film, a woven fabric, a non-woven fabric, a knit, a mesh, and a sponge. A non-woven fabric that is formed by overlapping fibrous carbon materials may be used.

An average thickness of the upper electrode 101 and an average thickness of the lower electrode 103 may be appropriately selected in accordance with a structure of the element, but it is preferable to set the average thicknesses from 0.01 micrometer (pm) to 1 mm, and more preferably, from 0.1 µm to 500 µm. If the average thicknesses are equal to or larger than 0.01 µm, it is possible to ensure appropriate mechanical strength and improve conductivity. Further, if the average thicknesses are equal to or smaller than 1 mm, the element is deformable, so that it is possible to ensure good power generation performance. Furthermore, it is particularly preferable to use a conductive rubber composition as the lower electrode 103.

The upper electrode 101 is one example of an upper electrode having an uneven structure. Specifically, the upper electrode 101 is an electrode that has an uneven structure on the surface that comes into contact with the intermediate layer 102 (to be described later). Therefore, because the upper electrode 101 has the uneven structure, it is possible to improve releasability between the upper electrode 101 and the intermediate layer 102. In the present embodiment, the upper electrode 101 can be bonded to the upper cover 100 and the intermediate layer 102 by a bonding layer 106 that is arranged on an end portion of the upper electrode 101.

The intermediate layer 102 is one example of a flexible intermediate layer and sandwiched between the upper electrode 101 and the lower electrode 103. Specifically, the intermediate layer 102 is a power generator and, as illustrated in FIG. 1B, one surface thereof comes into contact with (is bonded to) or is separated from the uneven structure of the upper electrode 101. Further, as illustrated in FIG. 1B, the lower electrode 103 (to be described later) is closely attached to a surface of the intermediate layer 102 opposite to the surface that comes into contact with or that is separated from the uneven structure of the upper electrode 101. Furthermore, it is preferable that a film thickness of the intermediate layer 102 is reduced to increase an amount of charges accumulated in the intermediate layer 102.

More preferably, the intermediate layer 102 meets at least any of a condition (1) and a condition (2) below.

Condition (1): when the intermediate layer 102 is pressed in a direction perpendicular to the surface of the intermediate layer 102, an amount of deformation of the intermediate layer 102 on the upper electrode 101 (one example of the first electrode) side and an amount of deformation of the intermediate layer 102 on the lower electrode 103 (one example of the second electrode) side are different.

Condition (2): universal hardness (H1) of the intermediate layer 102 on the upper electrode 101 side when the intermediate layer 102 is pressed by 10 µm and universal hardness (H2) of the intermediate layer 102 on the lower electrode 103 side when the intermediate layer 102 is pressed by 10 µm are different.

The intermediate layer 102 is able to achieve a large power generation amount because the amount of deformation or the hardness is different between the two surfaces as described above.

In the present embodiment, the amount of deformation is a maximum pressing depth of an indenter when the intermediate layer 102 is pressed under the condition below.

### Measurement condition

Measurement machine: ultra-micro hardness tester WIN-HUD manufactured by Fischer Instruments K.K.
Indenter: quadrangular pyramid diamond intender in which an angle between opposite faces is 136 degrees
Initial load: 0.02 millinewton (mN)
Maximum load: 1 mN
Load increasing time from initial load to maximum load: 10 seconds

Universal hardness is obtained by the method as described below.

### Measurement condition

Measurement machine: ultra-micro hardness tester WIN-HUD manufactured by Fischer Instruments K.K.
Indenter: quadrangular pyramid diamond intender in which an angle between opposite faces is 136 degrees
Pressing depth: 10 µm
Initial load: 0.02 mN
Maximum load: 100 mN
Load increasing time from initial load to maximum load: 50 seconds

A ratio (H1/H2) between the universal hardness (H1) and the universal hardness (H2) is preferably 1.01 or more, more preferably 1.07 or more, and particularly preferably 1.13 or more. An upper limit of the ratio (H1/H2) is not specifically limited and may be appropriately selected in accordance with, for example, a degree of flexibility that is needed in a use situation, a load in the use situation, or the like; however, it is preferable to set the upper limit to 1.70 or less. Here, H1 represents universal hardness of a relatively hard surface, and H2 represents universal hardness of a relatively soft surface.

A material of the intermediate layer 102 is not specifically limited and may be appropriately selected depending on intended purposes. For example, rubber, a rubber composition, or the like may be adopted.

Examples of the rubber include silicone rubber, acrylic rubber, chloroprene rubber, polysulfide rubber, urethane rubber, butyl rubber, natural rubber, ethylene-propylene rubber, nitrile rubber, fluorine-contained rubber, isoprene rubber, butadiene rubber, styrene-butadiene rubber, acrylonitrile-butadiene rubber, ethylene-propylene-diene rubber, chlorosulfonated polyethylene synthetic rubber, polyisobutylene, and modified silicone. One of the above-described materials may be used alone or two or more of the above-described materials may be used in combination. Among the above-described materials, silicone rubber is preferable.

The silicone rubber is not specifically limited as long as the rubber contains a siloxane linkage, and may be appropriately selected depending on intended purposes. Examples of the silicone rubber include dimethyl silicone rubber, methylphenyl silicone rubber, fluorosilicone rubber, modified silicone rubber (for example, acrylic modification, alkyd modification, ester modification, or epoxy modification). One of the above-described materials may be used alone or two or more of the above-described materials may be used in combination.

Examples of the rubber composition include compositions containing filler and the rubber. Among the compositions, a silicon rubber composition containing the silicone rubber is preferable because of high power generation performance.

Examples of the filler include organic filler, inorganic filler, and organic-inorganic composite filler. The organic filler is not specifically limited as long as it is an organic compound and may be appropriately selected depending on intended purposes. Examples of the organic filler include acrylic fine particles, polystyrene fine particles, melamine fine particles, fluorocarbon polymer fine particles, such as polytetrafluoroethylene, silicone powder (silicone resin powder, silicone rubber powder, silicone composite powder), rubber powder, wood powder, pulp, and starch. The inorganic filler is not specifically limited as long as it is an inorganic compound and may be appropriately selected depending on intended purposes.

Examples of the inorganic filler include an oxide, a hydroxide, a carbonate, a sulfate, a silicate, a nitride, carbons, metal, and other compounds.

Examples of the oxide include silica, diatomaceous earth, alumina, zinc oxide, titanium oxide, iron oxide, and magnesium oxide.

Examples of the hydroxide include aluminum hydroxide, calcium hydroxide, and magnesium hydroxide.

Examples of the carbonate include calcium carbonate, magnesium carbonate, barium carbonate, and hydrotalcite.

Examples of the sulfate include aluminum sulfate, calcium sulfate, and barium sulfate.

Examples of the silicate include calcium silicate (wollastonite and zonolite), zirconium silicate, kaolin, talc, mica, zeolite, perlite, bentonite, montmorillonite, sericite, activated clay, glass, and hollow glass bead.

Examples of the nitride include aluminum nitride, silicon nitride, and boron nitride.

Examples of the carbons include Ketjen black, acetylene black, graphite, a carbonaceous fiber, a carbon fiber, a carbon nanofiber, a carbon nanotube, a fullerene (including derivatives), and a graphene.

Examples of the metal include gold, silver, platinum, copper, iron, aluminum, and nickel.

Examples of the other compounds include potassium titanate, barium titanate, strontium titanate, lead zirconate titanate, silicon carbide, and molybdenum sulfide. The inorganic filler may be surface-treated.

The organic-inorganic composite filler can be used without particular limitation as long as it is a compound in which an organic compound and an inorganic compound are combined at a molecular level.

Examples of the organic-inorganic composite filter include silica-acrylic composite fine particles and silsesquioxane.

An average particle diameter of the filler is not specifically limited and may be appropriately selected depending on intended purposes; however, it is preferable to set the average particle to 0.01 µm to 30 µm, and more preferably, 0.1 µm to 10 µm. If the average particle diameter is 0.01 µm or more, power generation performance may be improved. Further, if the average particle diameter is 30 µm or less, the intermediate layer is deformable, so that it is possible improve the power generation performance.

The average particle diameter may be measured in accordance with a known method by using a known particle size distribution measurement apparatus, such as a microtrac HRA (manufactured by Nikkiso Co., Ltd.).

The content of the filler is preferably 0.1 parts by mass to 100 parts by mass, and more preferably, 1 part by mass to 50 parts by mass with respect to 100 parts by mass of the rubber. If the content is 0.1 part by mass or more, the power generation performance may be improved. Further, if the content is 100 parts by mass or less, the intermediate layer is deformable, so that it is possible to improve the power generation performance.

The other components are not specifically limited and may be appropriately selected depending on intended purposes. Examples of the other components include additives. The contents of the other components may be appropriately selected as long as the object of the present embodiment is not impaired.

Examples of the additives include a cross-linking agent, a reaction control agent, filler, a reinforcing material, an aging preventive agent, a conductivity control agent, a coloring agent, a plasticizing agent, a processing aid, a flame retardant, an ultraviolet absorbing agent, a tackifier agent, and a thixotropy imparting agent.

A method of preparing a material included in the intermediate layer 102 is not specifically limited and may be appropriately selected depending on intended purposes. For example, as a method of preparing the rubber composition, it is possible to prepare the rubber composition by mixing the rubber, the filler, and the other components if needed, and by performing kneading and dispersing.

A method of forming the intermediate layer 102 is not specifically limited and may be appropriately selected depending on intended purposes. For example, as a method of forming a thin film of the rubber or the rubber composition, it may be possible to adopt a method of applying the rubber or the rubber composition onto a base material by blade coating, die coating, dip coting, spin coating, or the like, and thereafter performing curing with heat, electron beam, moisture in air, or the like.

An average thickness of the intermediate layer 102 is not specifically limited and may be appropriately selected depending on intended purposes; however, it is preferable to set the average thickness to 0.01 µm to 10 mm, and more preferably 0.1 µm to 100 µm from the viewpoint of deformation followability. Further, if the average thickness is within the preferable range, it is possible to ensure film forming property and it is possible to prevent inhibition of deformation, so that it is possible to generate power in good condition; however, it is preferable to reduce a film thickness to increase the power generation amount.

It is preferable that the intermediate layer 102 has insulating property. As the insulating property, it is preferable to have a volume resistivity of 10⁸ ohm centimeters (Ωcm) or more, and more preferably, a volume resistivity of 10¹⁰ Qcm or more. The intermediate layer 102 may have a multi-layer structure.

The intermediate layer 102 may be subjected to surface modification treatment or deactivation treatment.

### Surface modification treatment

As the surface modification treatment, any of dry treatment and wet treatment is applicable, but the dry treatment is preferable. Examples of the dry treatment include plasma treatment, corona discharge treatment, electron beam irradiation treatment, ultraviolet ray irradiation treatment, ozone treatment, and radiation (X-ray, α-ray, β-ray, γ-ray, or neutron ray) irradiation treatment. Among the treatment as described above, the plasma treatment, the corona discharge treatment, and the electron beam irradiation treatment are preferable from the view point of treatment speed; however, the treatment is not limited to the above as long as it is possible to ensure a certain amount of irradiation energy and modify the material. The surface modification indicates chemical change in the surface of the intermediate layer.

### Plasma treatment

In the case of the plasma treatment, a plasma generation apparatus may be of a parallel plate type, a capacity coupling type, or an inductive coupling type, or may be an atmospheric pressure plasma apparatus, for example. From the view point of durability, low pressure plasma treatment is preferable.

Reaction pressure in the plasma treatment is not specifically limited and may be appropriately selected depending on intended purposes; however, it is preferable to set the reaction pressure to 0.05 pascal (Pa) to 100 Pa, and more preferably, 1 Pa to 20 Pa.

Reaction atmosphere in the plasma treatment is not specifically limited and may be appropriately selected depending on intended purposes. For example, certain gas, such as inert gas, rare gas, or oxygen, is effective, but argon is preferable from the viewpoint of sustainability of the effect. Further, in this case, it is preferable to set oxygen partial pressure to 5,000 parts per million (ppm) or less. If the oxygen partial pressure in the reaction atmosphere is 5,000 ppm or less, it is possible to prevent generation of ozone and avoid using an ozone treatment apparatus.

An irradiation power amount in the plasma treatment is defined by (output × irradiation time). The irradiation power amount is preferably 5 watt hour (Wh) to 200 Wh, and more preferably 10 Wh to 50 Wh. If the irradiation power amount is within the preferable range, it is possible to impart a power generation function to the intermediate layer 102 and prevent reduction in the durability due to excessive irradiation.

### Corona discharge treatment

Applied energy (accumulated energy) in the corona discharge treatment is preferably 6 joules per square centimeter (J/cm²) to 300 J/cm², and more preferably 12 J/cm² to 60 J/cm². If the applied energy is within the preferable range, it is possible to impart the power generation function to the intermediate layer 102 and prevent reduction in the durability due to excessive irradiation.

### Electron beam irradiation treatment

An irradiation amount in the electron beam irradiation treatment is preferably 1 kilogray (kGy) or more, and more preferably 300 kGy to 10 megagray (MGy). If the irradiation amount is within the preferable range, it is possible to impart the power generation function to the intermediate layer 102 and prevent reduction in the durability due to excessive irradiation. Reaction atmosphere in the electron beam irradiation treatment is not specifically limited and may be appropriately selected depending on intended purposes; however, it is preferable to fill the atmosphere with inert gas, such as argon, neon, helium, or nitrogen, and set the oxygen partial pressure to 5,000 ppm or less. If the oxygen partial pressure in the reaction atmosphere is 5,000 ppm or less, it is possible to prevent generation of ozone and avoid using an ozone treatment apparatus.

### Ultraviolet irradiation treatment

It is preferable that an ultraviolet ray in the ultraviolet irradiation treatment has a wavelength of 365 nanometers (nm) or less and 200 nm or more, and more preferably 320 nm or less and 240 nm or more. An accumulated light intensity in the ultraviolet irradiation treatment is preferably 5 J/cm² to 500 J/cm², and more preferably 50 J/cm² to 400 J/cm². If the accumulated light intensity is within the preferable range, it is possible to impart the power generation function to the intermediate layer 102 and prevent reduction in the durability due to excessive irradiation. Reaction atmosphere in the ultraviolet irradiation treatment is not specifically limited and may be appropriately selected depending on intended purposes; however, it is preferable to fill the atmosphere with inert gas, such as argon, neon, helium, or nitrogen, and set the oxygen partial pressure to 5,000 ppm or less. If the oxygen partial pressure in the reaction atmosphere is 5,000 ppm or less, it is possible to prevent generation of ozone and avoid using an ozone treatment apparatus.

As the conventional technique, a technique of forming an active group by causing excitation or oxidization to occur by plasma treatment, corona discharge treatment, ultraviolet irradiation treatment, electron beam irradiation treatment, or the like and enhancing interlayer adhesion has been proposed. However, it has been found that this technique is limited to application between layers, and application to an outermost surface rather reduces releasability, which is not preferable. Further, a reaction is carried out under an oxygen-rich state to effectively introduce a reaction active group (hydroxyl group). Therefore, the conventional technique as described above is different, in essence, from the surface modification treatment of the present embodiment.

The surface modification treatment of the present embodiment is treatment (for example, plasma treatment) in a reaction environment in which oxygen is reduced and pressure is reduced, and therefore promotes crosslinking and bonding, so that it is possible to improve the durability due to "increase in Si-O bond with high binding energy" and further improve the releasability due to "densification due to increase in crosslinking density" (meanwhile, some active groups are formed even in the present embodiment, but the active groups are deactivated by a coupling agent or air drying treatment to be described later).

### Deactivation treatment

The surface of the intermediate layer 102 may appropriately be subjected to deactivation treatment using various materials. The deactivation treatment is not specifically limited and may be appropriately selected depending on intended purposes as long as it is possible to deactivate the surface of the intermediate layer 102 through the treatment. For example, treatment of adding a deactivation agent to the surface of the intermediate layer 102 may be adopted. Deactivation indicates a change in the property of the surface of the intermediate layer 102 such that a chemical reaction is less likely to occur. This change is achieved by causing an active group (for example, -OH or the like) that is generated by excitation or oxidization through plasma treatment, corona discharge treatment, ultraviolet irradiation treatment, electron beam irradiation treatment, or the like to react with a deactivation agent and reducing an activation level of the surface of the intermediate layer 102.

Examples of the deactivation agent include amorphous resin and a coupling agent.

Examples of the amorphous resin include resin that has a perfluoropolyether structure in the main chain.

Examples of the coupling agent include metal alkoxide and a solution containing metal alkoxide. Examples of the metal alkoxide include a compound represented by Expression (1) below, a partial hydrolysis polycondensation material with a polymerization degree of about 2 to 10, and a mixture of the compound and the material.

R¹₍₄₋ₙ₎Si(OR²)ₙ (1)

However, R1 and R2 in Expression (1) above independently represent any of an alkyl group, an alkyl polyether chain, and an aryl group in a straight chain or a branched chain with 1 to 10 carbons. n represent an integer from 2 to 4.

Examples of the compound represented by Expression (1) above include dimethyldimethoxysilane, diethyldiethoxysilane, diethyldimethoxysilane, diethyldiethoxysilane, diphenyldimethoxysilane, diphenyldiethoxysilane, methyltrimethoxysilane, methyltriethoxysilane, tetramethoxysilane, tetraethoxysilane, and tetrapropoxysilane. Tetraethoxysilane is particularly preferable from the viewpoint of the durability.

In Expression (1) above, R1 may be a fluoroalkyl group, or may be fluoroalkylacrylate or etherperfluoropolyether that is bonded via oxygen. Perfluoropolyether is particularly preferable from the viewpoint of the flexibility and the durability.

Further, examples of the metal alkoxide include vinylsilanes (for example, vinyltris (β-methosyethoxy) silane, vinyltriethoxysilane, vinyltrimethoxysilane, and the like), acrylsilanes (for example, γ-methacryloxypropyltrimethoxysilane and the like), epoxysilanes (for example, β-(3,4-epoxycyclohexyl, ethyltrimethoxysilane, γ-glycidoxypropyltrimethoxysilane, γ-glycidoxypropylmethyldiethoxysilane, and the like), and aminosilanes (N-β(aminoethyl)γ-aminopropyltrimethoxysilane, N-β(aminoethyl)γ-aminopropylmethyldimethoxysilane, γ-aminopropyltriethoxysilane, N-phenyl-γ-aminopropyltrimethoxysilane, and the like).

Further, as the metal alkoxide, it is possible to use one of Ti, Sn, Al, and Zr or a combination of two or more of Ti, Sn, Al, and Zr as a metal atom, other than Si.

The deactivation treatment may be performed by, for example, performing the surface modification treatment on an intermediate layer precursor, such as the rubber, and thereafter impregnating the surface of the intermediate layer precursor with the deactivation agent by coating, dipping, or the like. Further, the deactivation may be achieved by plasma chemical vapor deposition (CVD), physical vapor deposition (PVD), sputtering, vacuum deposition, combustion chemical vapor deposition, or the like.

Furthermore, if silicone rubber is used as the intermediate layer precursor, the deactivation may be achieved by performing the surface modification treatment and thereafter performing air drying while the precursor is placed in a stationary manner in air.

It is preferable that an oxygen density profile in the thickness direction of the intermediate layer 102 has a local maximum value.

It is preferable that a carbon density profile in the thickness direction of the intermediate layer 102 has a local minimum value.

Then, in the intermediate layer 102, it is preferable that a position at which the oxygen density profile indicates the local maximum value and a position at which the carbon density profile indicates the local minimum value match with each other.

The oxygen density profile and the carbon density profile can be obtained by X-ray photoelectron spectroscopy (XPS). Examples of a measurement method include the followings.

### Measurement method

Measurement apparatus: Ulvac-PHI QuanteraSXM, manufactured by ULVAC-PHI Inc.
Measurement light source: Al (mono)
Measurement output power: 100 µmϕ, 25.1 W
Measurement region: 500 µm × 300 µm
Pass energy: 55 electron volts (eV) (narrow scan)
Energy step: 0.1 eV (narrow scan)
Relative sensitivity factor: relative sensitivity factor of PHI is used
Sputtering source: C60 cluster ion
Ion Gun output power: 10 kilovolts (kV), 10 nanoamperes (nA)
Raster Control: (X = 0.5, Y = 2.0) mm
Sputtering rate: 0.9 nanometers per minute (nm/min) (converted by SiO₂)

In the XPS, it is possible to recognize abundance and a bonding state of an atom in a measurement object by capturing an electron that is emitted due to the photoelectric effect.

The silicone rubber contains a siloxane linkage and contains, as main components, Si, O, and C. Therefore, if the silicone rubber is used as a material of the intermediate layer, it is possible to obtain the abundance in a depth direction of each of atoms that are present in a surface layer and an inner side by measuring wide scan spectrum of the XPS and using a relative peak intensity ratio among elements.

Further, in the case of the silicone rubber, it is possible to recognize an element that is bound with silicon and a bonding state by measuring energy with which an electron on a 2p orbital of Si is emitted. It is possible to obtain a chemical bonding state by resolving peak from narrow scan spectrum on the 2p orbital of Si that represents the bonding state of Si.

In general, it is known that the amount of peak shift depends on the bonding state, and in the case of the silicon rubber subjected to the surface treatment and/or the deactivation treatment as described above, it is observed that the peak shifts toward a higher energy side in the 2p orbital of Si, which indicates that the number of oxygens bound with Si is increased.

If certain surface treatment, such as the surface modification treatment or the deactivation treatment, is performed on the surface of the intermediate layer 102 on the upper electrode 101 side, the surface of the intermediate layer 102 on the upper electrode 101 side becomes harder than the surface of the intermediate layer 102 on the lower electrode 103 side. Therefore, the universal hardness H1 of the surface of the intermediate layer 102 on the upper electrode 101 side becomes higher than the universal hardness H2 of the surface of the intermediate layer 102 on the lower electrode 103 side. With this configuration, if a pressing force F that is the same deformation imparting force acts on both of the upper electrode 101 side and the lower electrode 103 side, a degree of deformation of the intermediate layer 102 on the upper electrode 101 side is smaller than that on the lower electrode 103 side, so that the uneven structure of the upper electrode 101 can be relatively largely embedded in the lower electrode 103. As a result, it is possible to increase the power generation amount of the power generation element 1.

The intermediate layer 102 need not have an initial surface potential in a stationary state. Meanwhile, the initial surface potential in the stationary state can be measured under a measurement condition below. Here, a state in which there is no initial surface potential means that the surface potential is ±10 V or less when measured under the measurement condition below.

### Measurement condition

Pre-processing: placed in a stationary state for 24 hours in an atmosphere at temperature of 30 degrees Celsius and relative humidity of 40%, and neutralization is performed for 60 seconds (SJ-F300 manufactured by Keyence is used)
Apparatus: Treck Model344
Measurement probe: 6000B-7C
Measurement distance: 2 mm
Measurement spot diameter: diameter (Φ) of 10 mm

From the above viewpoint, a different power generation principle from those of the technologies described in Japanese Unexamined Patent Application Publication No. 2009-253050, Japanese Unexamined Patent Application Publication No. 2014-027756, Japanese Unexamined Patent Application Publication No. S54-14696, and the like is adopted to the power generation element 1 according to the present embodiment. While any theoretical limitation is not imposed, it is regarded that the power generation element 1 (one example of the element) of the present embodiment generates electric charges due to separation between the upper electrode 101 and the intermediate layer 102 and generates electricity by causing the electric charges to move due to electrostatic induction caused by accumulation of the electric charges in the intermediate layer 102 at this time.

The lower electrode 103 (one example of the second electrode) is one example of a lower electrode that is closely attached to the intermediate layer 102. Further, the power generation element 1 is an element that generates an electrical signal due to contact or separation between the upper electrode 101 and the intermediate layer 102. Furthermore, as illustrated in FIG. 1B, the lower electrode 103 takes a shape that is fittable to the uneven structure of the upper electrode 101 when the upper electrode 101 and the intermediate layer 102 come into contact with each other. With this configuration, as illustrated in FIGS. 2A and 2B, when the upper electrode 101 and the intermediate layer 102 come into contact with each other (that is, when a load acts from the upper electrode 101 side to the lower electrode 103 side), the upper electrode 101 can fully be embedded in a power generator that is the intermediate layer 102, so that it is possible to increase a contact area between the upper electrode 101 and the intermediate layer 102. As a result, it is possible to further increase the power generation amount of the power generation element 1. Moreover, it is preferable that the lower electrode 103 maintains a certain shape that is fittable to the uneven structure of the upper electrode 101 when the upper electrode 101 and the intermediate layer 102 are separated from each other.

It is preferable that the power generation element 1 (one example of the element) of the present embodiment has a space at least between the intermediate layer 102, the upper electrode 101 (one example of the first electrode), and the lower electrode 103 (one example of the second electrode). With this configuration, it is possible to increase the power generation amount.

A method of arranging the space is not specifically limited and may be appropriately selected depending on intended purposes. For example, a method of arranging a spacer at least between the intermediate layer 102, the upper electrode 101 (one example of the first electrode), and the lower electrode 103 (one example of the second electrode) may be adopted.

A material, a form, a shape, a size, and the like of the spacer are not specifically limited and may be appropriately selected depending on intended purposes. Examples of the material of the spacer include a polymer material, rubber, metal, a conductive polymer material, and a conductive rubber composition.

Examples of the polymer material include polyethylene, polypropylene, polyethylene terephthalate, polyvinyl chloride, polyimide resin, fluorocarbon polymer, and acrylic resin. Examples of the rubber include silicone rubber, acrylic rubber, chloroprene rubber, polysulfide rubber, urethane rubber, butyl rubber, natural rubber, ethylene-propylene rubber, nitrile rubber, fluorine-contained rubber, isoprene rubber, butadiene rubber, styrene-butadiene rubber, acrylonitrile-butadiene rubber, ethylene-propylene-diene rubber, chlorosulfonated polyethylene synthetic rubber, polyisobutylene, and modified silicone.

Examples of the metal include gold, silver, copper, aluminum, stainless steel, tantalum, nickel, and phosphor bronze. Examples of the conductive polymer material include polythiophene, polyacetylene, and polyaniline. Examples of the conductive rubber composition include a composition containing conductive filler and rubber. Examples of the conductive filler include a carbon material (for example, Ketjen black, acetylene black, graphite, a carbonaceous fiber, a carbon fiber, a carbon nanofiber, a carbon nanotube, graphene, and the like), metal (for example, gold, silver, platinum, copper, iron, aluminum, nickel, and the like), a conductive polymer material (for example, derivatives of any of polythiophene, polyacetylene, polyaniline, polypyrrole, poly(p-phenylene), and poly(p-phenylene vinylene), those obtained by adding a dopant represented by anion or cation to the derivatives as described above, and the like), and ionic liquid.

Examples of the rubber include silicone rubber, acrylic rubber, chloroprene rubber, polysulfide rubber, urethane rubber, butyl rubber, natural rubber, ethylene-propylene rubber, nitrile rubber, fluorine-contained rubber, isoprene rubber, butadiene rubber, styrene-butadiene rubber, acrylonitrile-butadiene rubber, ethylene-propylene-diene rubber, chlorosulfonated polyethylene synthetic rubber, polyisobutylene, and modified silicone.

Examples of a form of the spacer include a sheet, a film, a woven fabric, a non-woven fabric, a mesh, and a sponge.

Examples of an arrangement pattern of the spacer include a dot, a line, and a grid.

A shape, a size, a thickness, and an installation position of the spacer may be appropriately selected depending on a structure of the element.

The power generation element 1 (one example of the element) of the present embodiment may include, for example, an upper cover member and a lower cover member as other members. Materials, shapes, sizes, thicknesses, and structures of the upper and lower cover members are not specifically limited and may be appropriately selected depending on intended purposes.

Examples of the materials of the cover members include a polymer material and rubber.

Examples of the polymer material include polyethylene, polypropylene, polyethylene terephthalate, polyvinyl chloride, polyimide resin, fluorocarbon polymer, and acrylic resin.

Examples of the rubber include silicone rubber, modified silicone rubber, acrylic rubber, chloroprene rubber, polysulfide rubber, urethane rubber, butyl rubber, fluorosilicone rubber, natural rubber, ethylene-propylene rubber, nitrile rubber, fluorine-contained rubber, isoprene rubber, butadiene rubber, styrene-butadiene rubber, acrylonitrile-butadiene rubber, ethylene-propylene-diene rubber, chlorosulfonated polyethylene synthetic rubber, and polyisobutylene. A rubber material is preferable as the lower cover.

The lower cover 104 is arranged on a surface of the lower electrode 103 opposite to the surface that is closely attached to the intermediate layer 102. In this case, it is assumed that the lower cover 104 takes a shape that is fittable to the uneven structure of the upper electrode 101 together with the lower electrode 103 when the upper electrode 101 and the intermediate layer 102 come into contact with each other. With this configuration, when the upper electrode 101 and the intermediate layer 102 come into contact with each other, the upper electrode 101 can fully be embedded in the power generator that is the intermediate layer 102, so that it is possible to increase the contact area between the upper electrode 101 and the intermediate layer 102. As a result, it is possible to further increase the power generation amount of the power generation element 1.

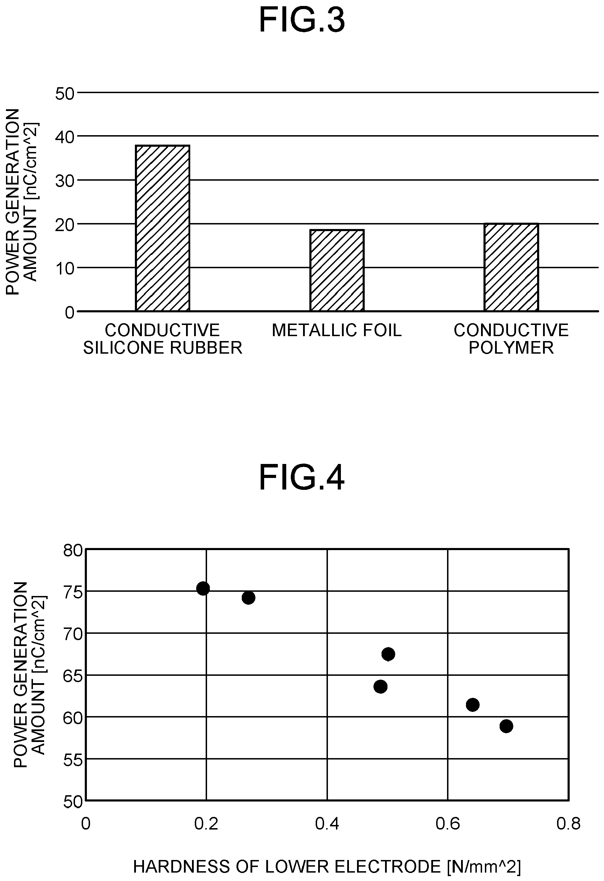

FIG. 3 is a diagram illustrating an example of the power generation amount of the power generation element according to the present embodiment. In FIG. 3, a vertical axis represents the power generation amount of the power generation element 1, and a horizontal axis represents the material used for the lower electrode 103. An example of a difference in the power generation amount of the power generation element 1 due to a difference in the material used for the lower electrode 103 will be described below with reference to FIG. 3.

As illustrated in FIG. 3, as compared to a case in which metallic foil (for example, aluminum foil) or a conductive polymer (film thickness of 4 µm) that can hardly be deformed into a certain shape that is fittable to the uneven structure of the upper electrode 101 is used as the lower electrode 103, the power generation amount of the power generation element 1 increases in a case in which conductive silicone rubber that can easily be deformed into a certain shape that is fittable to the uneven structure of the upper electrode 101 is used as the lower electrode 103. Therefore, it is preferable to use, as the lower electrode 103, a material (for example, conductive silicone rubber) that can easily be deformed into a certain shape that is fittable to the uneven structure of the upper electrode 101. With this configuration, it is possible to further increase the power generation amount of the power generation element 1.

FIG. 4 is a diagram illustrating an example of the power generation amount of the power generation element according to the present embodiment. In FIG. 4, a vertical axis represents the power generation amount of the power generation element 1, and a horizontal axis represents hardness of the lower electrode 103 (conductive silicone rubber with the film thickness of 10 µm). An example of a difference in the power generation amount of the power generation element 1 due to a difference in the hardness of the lower electrode 103 will be described below with reference to FIG. 4.

As illustrated in FIG. 4, with a decrease in the hardness of the lower electrode 103 and an increase in ease of fitting to the uneven structure of the upper electrode 101, the power generation amount of the power generation element 1 increases. Therefore, it is preferable to use, as the lower electrode 103, a lower electrode with hardness at which deformation into a certain shape that is fittable to the uneven structure of the upper electrode 101 can be performed easily. With this configuration, it is possible to further increase the power generation amount of the power generation element 1.

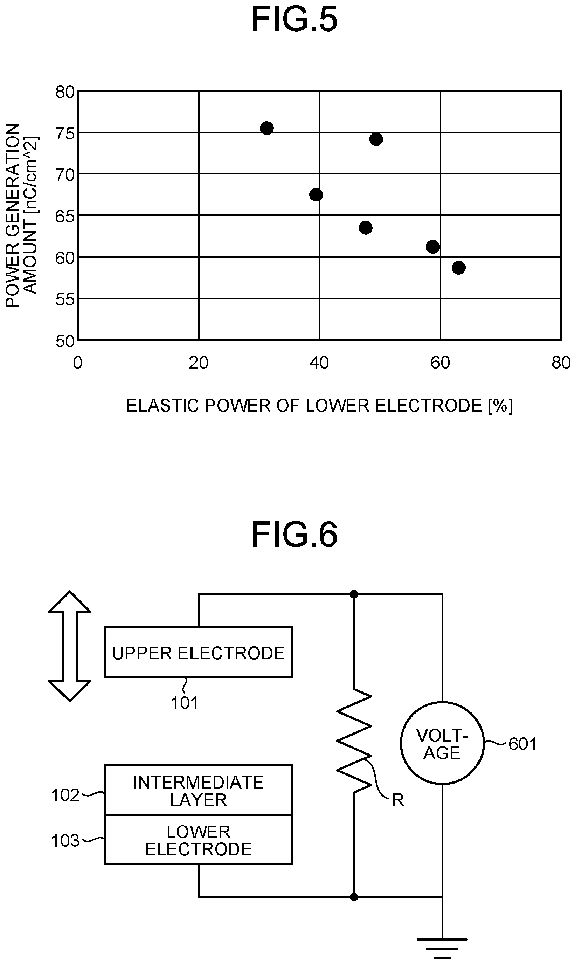

FIG. 5 is a diagram illustrating an example of the power generation amount of the power generation element according to the present embodiment. In FIG. 5, a vertical axis represents the power generation amount of the power generation element 1, and a horizontal axis represents elastic modulus (elastic power) of the lower electrode 103. An example of a difference in the power generation amount of the power generation element 1 due to a difference in the elastic modulus of the lower electrode 103 will be described below with reference to FIG. 5.

As illustrated in FIG. 5, with a decrease in the elastic modulus of the lower electrode 103 and an increase in the contact area between the upper electrode 101 and the intermediate layer 102 (in other words, with an increase in ease of fitting to the uneven structure of the upper electrode 101), the power generation amount of the power generation element 1 increases. Therefore, it is preferable to use, as the lower electrode 103, a lower electrode with an elastic modulus at which deformation into a certain shape that is fittable to the uneven structure of the upper electrode 101 can be performed easily. With this configuration, it is possible to further increase the power generation amount of the power generation element 1.

In this manner, according to the power generation element 1 of the present embodiment, the upper electrode 101 can fully be embedded into the power generator that is the intermediate layer 102 when the upper electrode 101 and the intermediate layer 102 come into contact with each other, so that it is possible to increase the contact area between the upper electrode 101 and the intermediate layer 102. As a result, it is possible to further increase the power generation amount of the power generation element 1.

### First Example

A first example is an example in which the power generation amount of the power generation element 1 is measured by changing the material of the lower electrode 103.

FIG. 6 is a diagram illustrating an example of a measurement apparatus used to measure the power generation amount of the power generation element according to the first example. In the present example, a measurement apparatus 600 includes, as illustrated in FIG. 6, an oscilloscope 601 (for example, WAVEACE1001 manufactured by Teledyne Japan Corporation) that is able to measure voltage at both ends of a resistor R (10 megaohms (MΩ)) connected to the upper electrode 101 and the lower electrode 103. Here, a fabric electrode (for example, Sui-10-70 manufactured by Seiren Co., Ltd.) is used for the upper electrode 101. Further, silicone rubber (KE-106 manufactured by Shin-Etsu Chemical Co., Ltd.) is used for the intermediate layer 102. Specifically, the intermediate layer 102 may be formed by applying silicone rubber to the lower electrode 103 by blade coating, forming a film with a film thickness of 15 µm by performing curing for 5 minutes at 120 degrees Celsius by oven, and performing electron beam irradiation treatment (EE-L-RC01 manufactured by Hamamatsu Photonics K.K.). The lower electrode 103 is fixed onto a stage of the measurement apparatus 600 and connected to GND. Further, the hardness and the elastic modulus of the lower electrode 103 are measured by using a micro hardness testing machine (FISHER SCOPE HM2000 manufactured by Fischer Instruments K.K., and an indenter is Vickers indenter).

In the present example, as illustrated in FIG. 6, the measurement apparatus 600 is configured such that the upper electrode 101 is movable in a vertical direction to enable contact and separation operation of the upper electrode 101 with respect to the intermediate layer 102. Then, the measurement apparatus 600 converts waveforms of voltage that are measured by the oscilloscope 601 when the upper electrode 101 comes in contact with and is separated from the intermediate layer 102 into amounts of moved charges, and calculates a total value of the amounts as the power generation amount. For example, the measurement apparatus 600 calculates the power generation amount at the 50-th contact and separation between the upper electrode 101 and the intermediate layer 102.

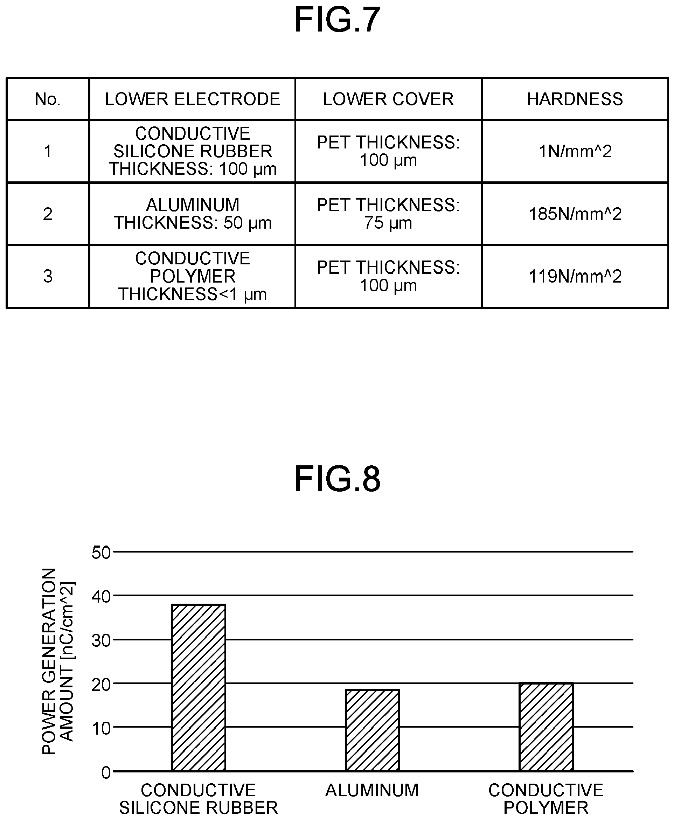

FIG. 7 is a diagram illustrating an example of a material of the lower electrode that is used to measure the power generation amount of the power generation element according to the first example. FIG. 8 is a diagram illustrating an example of a measurement result of the power generation amount of the power generation element according to the first example. In FIG. 8, a vertical axis represents the power generation amount of the power generation element 1, and a horizontal axis represents the material of the lower electrode 103. An example of the measurement result of the power generation amount of the power generation element 1 obtained by the measurement apparatus 600 illustrated in FIG. 6 will be described below with reference to FIG. 7 and FIG. 8.

As illustrated in FIG. 7 and FIG. 8, the power generation amount of the power generation element 1 is maximized when conductive silicone rubber is used as the lower electrode 103. This may be because, with a decrease in the hardness of the lower electrode 103, the lower electrode 103 can more easily be deformed when the upper electrode 101 and the intermediate layer 102 come into contact with each other, so that it becomes easy to form a fitting shape between the upper electrode 101 and the intermediate layer 102 and increase the contact area between the upper electrode 101 and the intermediate layer 102.

### Second Example

A second example is an example in which the power generation amount of the power generation element 1 is measured by changing the hardness of the lower electrode 103 (for example, conductive silicone rubber with a film thickness of 100 µm). Even in the present example, similarly to the first example, the power generation amount of the power generation element 1 is measured by using the measurement apparatus 600 illustrated in FIG. 6.

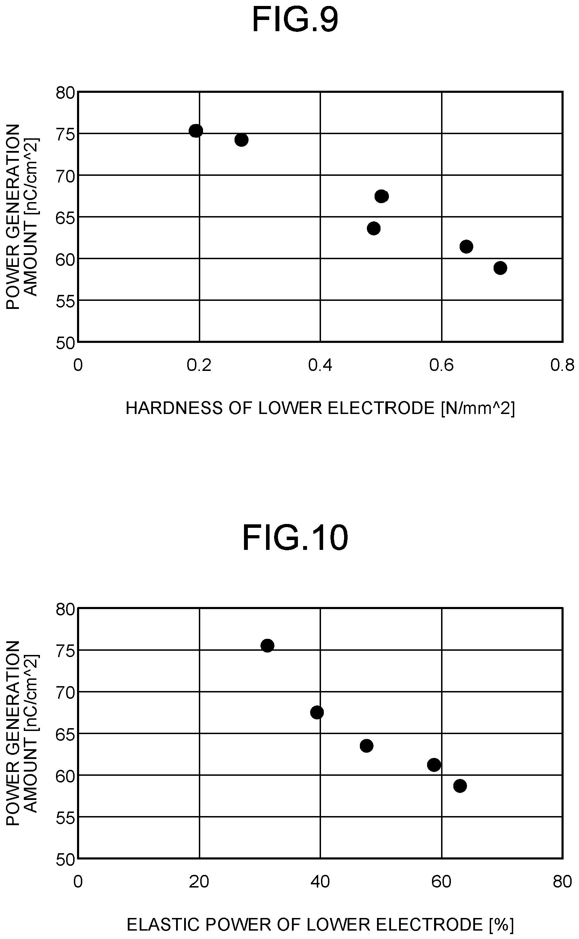

FIG. 9 is a diagram illustrating an example of a measurement result of the power generation amount of the power generation element according to the second example. In FIG. 9, a vertical axis represents the power generation amount of the power generation element 1, and a horizontal axis represents the hardness of the lower electrode 103. As illustrated in FIG. 9, a result indicating that the power generation amount of the power generation element 1 is increased with a decrease in the hardness of the lower electrode 103 is obtained. This may be because, with a decrease in the hardness of the lower electrode 103, the lower electrode 103 can more easily be deformed when the upper electrode 101 and the intermediate layer 102 come into contact with each other, so that it becomes easy to form a fitting shape between the upper electrode 101 and the intermediate layer 102 and increase the contact area between the upper electrode 101 and the intermediate layer 102.

### Third Example

A third example is an example in which the power generation amount of the power generation element 1 is measured by changing the elastic modulus (elastic power) of the lower electrode 103 (for example, conductive silicone rubber with a film thickness of 100 µm). Even in the present example, similarly to the first example, the power generation amount of the power generation element 1 is measured by using the measurement apparatus 600 illustrated in FIG. 6.

FIG. 10 is a diagram illustrating an example of a measurement result of the power generation amount of the power generation element according to the third example. In FIG. 10, a vertical axis represents the power generation amount of the power generation element 1, and a horizontal axis represents the elastic power of the lower electrode 103. As illustrated in FIG. 10, a result indicating that the power generation amount of the power generation element 1 is increased with a decrease in the elastic power of the lower electrode 103 is obtained. The power generation amount of the power generation element 1 tends to be saturated with an increase in the contact area between the upper electrode 101 and the intermediate layer 102 due to repetition of contact and separation between the upper electrode 101 and the intermediate layer 102. This may because, in the situation as described above, if the elastic modulus of the lower electrode 103 is small, a deformed state of the lower electrode that is formed when the upper electrode 101 and the intermediate layer 102 come into contact with each other can easily be maintained and the contact area between the upper electrode 101 and the intermediate layer 102 can easily be stabilized. Therefore, the power generation amount of the power generation element 1 is increased with a decrease in the elastic power of the lower electrode 103.

According to one aspect of the present invention, it is possible to further increase a power generation amount of a flexible element.

The above-described embodiments are illustrative and do not limit the present invention. Thus, numerous additional modifications and variations are possible in light of the above teachings. For example, at least one element of different illustrative and exemplary embodiments herein may be combined with each other or substituted for each other within the scope of this disclosure and appended claims. Further, features of components of the embodiments, such as the number, the position, and the shape are not limited the embodiments and thus may be preferably set. It is therefore to be understood that within the scope of the appended claims, the disclosure of the present invention may be practiced otherwise than as specifically described herein.

## Claims

1. An element comprising:
an upper electrode having an uneven structure;
a flexible intermediate layer; and
a lower electrode closely attached to the intermediate layer, wherein
the element is configured to generate an electrical signal due to contact and separation between the upper electrode and the intermediate layer, and
the lower electrode is configured to take a shape fittable to the uneven structure when the upper electrode and the intermediate layer come into contact with each other.

2. The element according to claim 1, wherein the lower electrode is configured to maintain the shape fittable to the uneven structure when the upper electrode and the intermediate layer are separated from each other.

3. An element comprising:
an upper electrode having an uneven structure;
a flexible intermediate layer;
a lower electrode closely attached to the intermediate layer; and
a lower cover arranged on a surface of the lower electrode opposite to a surface of the lower electrode closely attached to the intermediate layer, wherein
the element is configured to generate an electrical signal due to contact and separation between the upper electrode and the intermediate layer, and
the lower electrode and the lower cover take shapes fittable to the uneven structure when the upper electrode and the intermediate layer come into contact with each other.
